Europäisches Patentamt

(19) European Patent Office

Office européen des brevets

(11) Numéro de publication : **0 063 843**
**B1**

(12) **FASCICULE DE BREVET EUROPÉEN**

(45) Date de publication du fascicule du brevet :
28.08.85

(51) Int. Cl.⁴ : **H 01 L 25/16, H 01 L 23/54**

(21) Numéro de dépôt : **82200455.2**

(22) Date de dépôt : **14.04.82**

(54) **Circuit hyperfréquences.**

(30) Priorité : 29.04.81 FR 8108548

(43) Date de publication de la demande :
03.11.82 Bulletin 82/44

(45) Mention de la délivrance du brevet :
28.08.85 Bulletin 85/35

(84) Etats contractants désignés :
**BE DE FR GB NL SE**

(56) Documents cités :
GB-A- 2 046 514
US-A- 3 374 110
IEEE TRANSACTIONS ON PARTS, HYBRIDS, AND
PACKAGING, vol.PHP8, no.2, juin 1972, New York
(US) H.R. ISAAK et al.: "Development of large thickfilm multilayer assemblies", pages 20-29
SOLID STATE TECHNOLOGY, vol.11, no.9, septembre 1968, Washington (US) G. AFFLECK et al.: "Plated
through-holes with photo-etched traces", pages 33-
35

(73) Titulaire : **TELECOMMUNICATIONS RADIOELECTRI-
QUES ET TELEPHONIQUES T.R.T.**
**88, rue Brillat Savarin**
**F-75013 Paris (FR)**
**FR**
**N.V. Philips' Gloeilampenfabrieken**
**Groenewoudseweg 1**
**NL-5621 BA Eindhoven (NL)**
**BE DE GB NL SE**

(72) Inventeur : **Kersuzan, Georges**
**SOCIETE CIVILE S.P.I.D. 209 rue de l'Université**
**F-75007 Paris (FR)**
Inventeur : **Picault, Michel**
**SOCIETE CIVILE S.P.I.D. 209 rue de l'Université**
**F-75007 Paris (FR)**
Inventeur : **Sourdillon, Rolland**
**SOCIETE CIVILE S.P.I.D. 209 rue de l'Université**
**F-75007 Paris (FR)**

(74) Mandataire : **Charpail, François et al**
**Société Civile S.P.I.D. 209, rue de l'Université**
**F-75007 Paris (FR)**

## Description

L'invention concerne un circuit hyperfréquence réalisé selon les technologies « hybride » et par sérigraphie sur une plaquette isolante d'alumine. La première face de ladite plaquette devant servir de support à un circuit comportant des trajets de connexions conductrices en or et la seconde face devant servir de support au plan de masse dudit circuit, la liaison circuit-plan de masse étant assurée au moyen de trous pratiqués à travers ladite plaquette et métallisés.

L'invention concerne également un procédé de réalisation de ce circuit.

L'article de H. R. ISAAK dans IEEE Transactions on Parts, Hybrids and Packaging (vol. PHP8, n° 2, Juin 1972) décrit une structure multicouches réalisée selon les technologies mentionnées dans le préambule et dans laquelle les trajets de connexions conductrices du circuit, la métallisation des trous et le plan de masse sont obtenus par des dépôts d'or par sérigraphie, solution particulièrement onéreuse. Si le circuit comporte éventuellement des résistances, celles-ci sont également déposées par sérigraphie. Les autres composants sont reportés sur le circuit selon la technologie « hybride ».

Le but de l'invention est de réaliser un circuit hyperfréquences, toujours selon les technologies mentionnées ci-dessus, mais d'une façon plus économique en remplaçant l'or du plan de masse par un alliage à base d'argent. Ledit plan de masse constituant la surface de dépôt d'or la plus importante, on doit ainsi réaliser une économie appréciable. Mais une difficulté se présente pour assurer la liaison du plan de masse avec les trajets de connexions conductrices du circuit du fait de la diffusion de l'argent dans l'or, le contact entre ces deux métaux formant du point de vue métallurgique une combinaison instable. Pour pallier cet inconvénient, le circuit hyperfréquence conforme à l'invention est caractérisé en ce que ledit plan de masse étant réalisé au moyen du dépôt d'un alliage à base d'argent, la liaison circuit-plan de masse est assurée par interposition dans le trajet de métallisation de chacun desdits trous d'un alliage compatible à la fois avec l'or desdits trajets de connexions conductrices et avec l'alliage à base d'argent dudit plan de masse.

Si ledit plan de masse est constitué par un alliage d'argent-palladium et si ladite liaison circuit-plan de masse est constituée par un alliage d'or-platine, le système ainsi réalisé est parfaitement stable du point de vue métallurgique grâce à l'or-platine faisant une barrière de diffusion de l'argent dans l'or.

La description suivante en regard des dessins annexés, le tout donné à titre d'exemple fera bien comprendre comment l'invention peut être réalisée.

Les figures 1 à 4 illustrent les étapes successives de la réalisation d'un circuit hyperfréquence conformément à l'invention.

Les figures 1a et 1b représentent respectivement une coupe transversale et une vue de dessus d'une plaquette d'alumine 3 au niveau d'un trou 4 pratiqué à travers ladite plaquette. Une métallisation d'or 5 dudit trou est d'abord effectuée au moyen d'un dépôt par sérigraphie sur l'une des faces 1 de la plaquette à partir d'une circonférence 6 concentrique au trou 4, de manière à le métalliser au maximum, ledit dépôt d'or étant suivi d'un séchage et d'une cuisson.

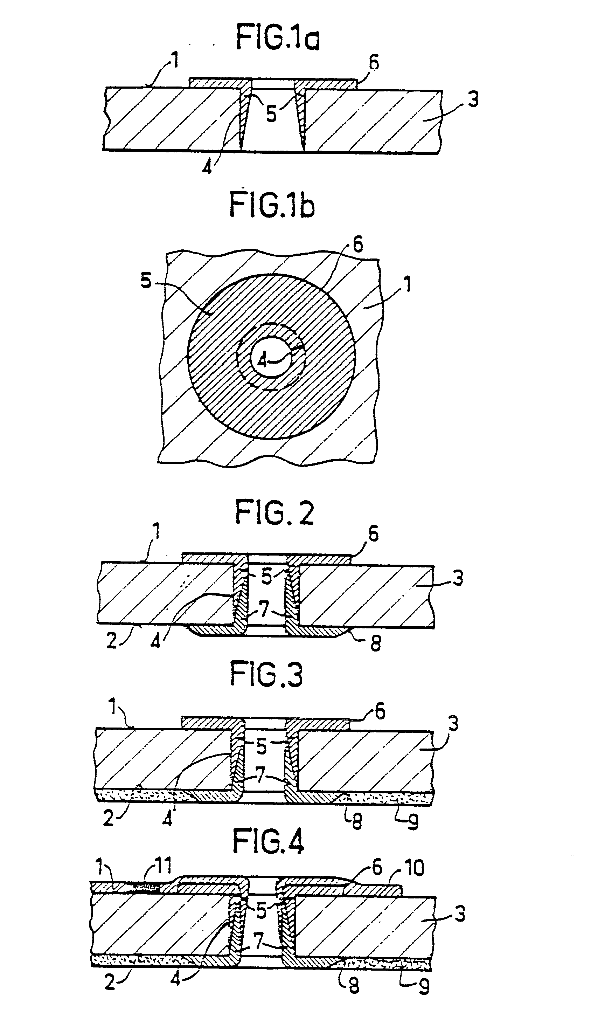

Dans l'étape suivante représentée sur la figure 2, une métallisation d'or-platine 7 du trou 4, superposée à la précédente métallisation d'or est obtenue au moyen d'un dépôt par sérigraphie sur l'autre face 2 de la plaquette à partir d'une circonférence 8 concentrique au trou 4 de manière à le métalliser au maximum, le dépôt d'or-platine étant suivi d'un séchage et d'une cuisson.

Conformément à la figure 3, on procède ensuite au dépôt par sérigraphie de l'argent-palladium d'un plan de masse 9 sur toute la superficie de la face 2 de la plaquette et de manière à obtenir au niveau de chaque trou 4 un léger recouvrement avec la partie de la métallisation d'or-platine 7 qui déborde à l'extérieur du trou, ledit dépôt d'argent-palladium étant suivi d'un séchage et d'une cuisson.

Sur la figure 4 est représenté le circuit achevé, complété dans la dernière étape de la réalisation par les dépôts d'or par sérigraphie sur la face 1 de la plaquette et suivant les trajets de connexions conductrices 10. Au niveau d'un trou 4, ces trajets sont réalisés de manière à recouvrir entièrement la partie de la métallisation d'or 5 qui déborde à l'extérieur du trou et partiellement la métallisation d'or-platine 7 à l'intérieur du trou. Eventuellement on dépose par sérigraphie les résistances 11 du circuit qui est ainsi prêt à recevoir les autres composants reportés. Les dépôts d'or des connexions et de pâte résistive sont suivis de même d'un séchage et d'une cuisson.

## Revendications

1. Circuit hyperfréquences réalisé selon les technologies « hybride » et par sérigraphie sur une plaquette isolante d'alumine, la première face de ladite plaquette devant servir de support à un circuit comportant des trajets de connexions conductrices en or et la seconde face devant servir de support au plan de masse dudit circuit, la liaison circuit-plan de masse étant assurée au moyen de trous pratiqués à travers ladite plaquette et métallisés, caractérisé en ce que ledit plan de masse est réalisé au moyen du dépôt d'un alliage à base d'argent, la liaison circuit-plan de masse de chacun desdits trous d'un alliage compatible à la fois avec l'or desdits trajets de connexions conductrices et avec l'alliage à base d'argent dudit plan de masse.

2. Circuit selon la revendication 1, caractérisé en ce que ledit plan de masse est constitué par un alliage d'argent-palladium et ladite liaison circuit-plan de masse est constituée par un alliage d'or-platine.

3. Procédé de réalisation du circuit hyperfréquences selon les revendications 1 à 2, caractérisé en ce que chacun desdits trous (4) est d'abord métallisé à l'or (5) déposé par sérigraphie sur ladite première face (1) à partir d'une première circonférence (6) concentrique audit trou et ensuite à l'or-platine (7) déposé par sérigraphie sur ladite seconde face (2) à partir d'une deuxième circonférence (8) concentrique audit trou, ledit plan de masse étant réalisé au moyen d'un dépôt par sérigraphie d'argent-palladium (9) sur ladite seconde face de manière à obtenir un léger recouvrement avec la partie de la métallisation d'or-platine débordant de chacun desdits trous jusqu'à ladite deuxième circonférence, lesdits trajets de connexions conductrices étant obtenus au moyen de dépôts d'or (10) par sérigraphie sur ladite première face et réalisés de manière à recouvrir entièrement la partie de la métallisation d'or débordant de chacun desdits trous jusqu'à ladite première circonférence et partiellement la métallisation d'or-platine à l'intérieure desdits trous.

## Claims

1. An ultra high-frequency circuit manufactured according to be « hybrid » technologies and by silk-screen printing on an insulating aluminium oxide plate, the first face of the said plate serving as a support for a circuit comprising conductive connection tracks of gold and the second face serving as a support for the mass surface of the said circuit, the connection between the circuit and the mass surface being provided by means of metallized holes in the said plate, characterized in that the said mass surface is manufactured by means of the deposition of a silver-based alloy, the connection between the circuit and the mass surface being ensured by the interposition in the metallization track of each of the said holes of an alloy which is compatible both with the gold of the said conductive connection tracks and with the silver-based alloy of the said mass surface.

2. A circuit as claimed in Claim 1, characterized in that the said mass surface is constituted by a silver-palladium alloy and the said connection between the circuit and the mass surface is constituted by a gold-platinum alloy.

3. A method of manufacturing the ultra high-frequency circuit as claimed in Claims 1 and 2, characterized in that each of the said holes (4) is first metallized with gold (5) deposited by silk-screen printing on the said first face (1) from a first circumference (6) which is concentric with the said hole and then of gold-platinum (7) deposited by silk-screen printing on the said second face (2) from a second circumference (8) which is concentric with the said hole, the said mass surface being made by means of a deposition by silk-screen printing of silver palladium (9) on the said second face so as to overlap a small part of the metallization of gold-platinum hextending from each of the said holes up to the said second circumference, the said conductive connection tracks being obtained by means of depositions of gold (10) by silk-screen printing on the said first face and executed so as to entirely cover the part of the metallization of gold extending from each of the said holes up to the said first circumference and to partly cover the metallization of gold-platinum on the inside of the said holes.

## Patentansprüche

1. Hyperfrequenzschaltung, hergestellt entsprechend der « Hybrid » Technologie und durch Siebdrucken auf eine isolierende Aluminiumoxidplatte, wobei die erste Fläche dieser Platte als Träger für eine Schaltungsanordnung mit leitenden Verbindungsspuren aus Gold dient und die zweite Fläche als Träger für die Masse der genannten Schaltungsanordnung dient, wobei die Verbindung zwischen der Schaltungsfläche und der Massenfläche durch Löcher in der Platte gewährleistet wird und wobei die Löcher metallisiert werden, dadurch gekennzeichnet, dass die genannte Massenfläche durch Niederschlagen einer Legierung auf Basis von Silber hergestellt wird, wobei die Verbindung zwischen der Schaltungsfläche und der Massenfläche dadurch gewährleistet wird, dass die Metallisierungsstrecke jedes der Löcker mit einer Legierung versehen wird, die mit dem Gold der leitenden Verbindungsspuren und mit der Legierung auf Basis von Silber der Massenfläche kompatibel ist.

2. Schaltungsanordnung nach Anspruch 1, dadurch gekennzeichnet, dass die Massenfläche aus einer Silber-Palladium-Legierung besteht und die Verbindung zwischen der Schaltungs- und Massenfläche aus einer Gold-Platin-Legierung.

3. Schaltungsanordnung nach Anspruch 1 und 2, dadurch gekennzeichnet, dass jedes der Löcher (4) zunächst mit Gold (5) metallisiert wird, das im Siebdruckverfahren auf der ersten Fläche (1) aus einem ersten Umkreis (6), der zu dem genannten Loch konzentrisch ist, niedergeschlagen wird und dass danach im Siebdruckverfahren auf der zweiten Fläche (2) aus einem zweiten Umkreis (8), der zu dem genannten Loch konzentrisch ist, Gold-Platin abgelagert wird, wobei die Massenfläche durch Siebdruck von Silber-Palladium (9) auf der zweiten Fläche hergestellt wird, wodurch eine dünne Bedeckung mit dem Teil der Gold-Platin-Metallisierung von jedem der Löcher bis an den genannten zweiten Umkreis erhalten wird, wobei die leitenden Verbindungsspuren durch Siebdrucken von Gold (10) auf der ersten Fläche erhalten werden, wodurch der ganze Teil der Metallisierung von Gold, das sich von jedem der Löcher zu dem genannten ersten Umkreis erstreckt und teilweise die Metallisierung von Gold-Platin auf der Innenseite der genannten Löcher erhalten wird.

# FIG.1a

# FIG.1b

# FIG. 2

# FIG.3

# FIG.4